# EUROPÄISCHE PATENTANMELDUNG

(11) **EP 0 522 335 A2**
(43) Veröffentlichungstag der Anmeldung: **13.01.1993**
(21) Anmeldenummer: 92110429.5
(22) Anmeldetag: 20.06.1992
(51) Int. Cl.: C22B 1/00, H05K 13/04

(54) **Verfahren zum Entfernen von Leiterplattenbestückungen**

(30) Priorität: 09.07.1991 DE 4122615
(71) Anmelder: Dipl.-Ing. SF-Ing. MANFRED BAHNEMANN RECYCLING-SYSTEME GmbH, D-78259 Mühlhausen-Ehingen (DE)
(72) Erfinder: Matijas, Jovan, W-7701 Mühlhausen/Ehingen (DE)
(74) Vertreter: Weiss, Peter, Dr. rer.nat.

(57) **Zusammenfassung**

Bei einem Verfahren zum Entfernen von Leiterplattenbestückungen, welche mit der Leiterplatte über Anschlußfahnen od. dgl. verbunden sind, soll eine bestückte Leiterplatte mit einem Mittel zur Lösung der Bestückungsverbindung, wie Wärme, eine Chemikalie od. dgl. beaufschlagt und die Bestückung sodann mechanisch entfernt werden.

## Beschreibung

Die Erfindung betrifft ein verfahren zum Entfernen von Leiterplattenbestückungen, welche mit der Leiterplatte über Anschlußfahnen od.dgl. verbunden sind.

Im Zuge des Umweltgedankens werden immer weitere Gebiete einem Recycling zugänglich gemacht. Dies gilt vor allem für solche Produkte, welche entweder sehr umweltschädlich sind oder aber sehr wertvolle Rohstoffe beinhalten, für die es sich lohnt, daß sie wiedergewonnen werden. Dies gilt z.B. für Leiterplatten, welche in elektronischen Geräten, isbesondere in Computern vorhanden sind. Bekanntermaßen beinhalten diese Leiterplatten einen erheblichen Anteil an Edelmetallen, wie Gold, Silber oder Platin. Für die Rückgewinnung dieser Edelmetalle von den Leiterplatten gibt es verschiedene bekannte Verfahren, wobei sich jedoch immer störend auswirkt, daß die Leiterplatten noch mit Schaltungselementen, wie Widerstände, Kondensatoren, Transistoren u.s.w. bestückt sind. Diese Schaltungselemente werden heute von Hand entfernt, wobei insbesondere die Anschlußfahnen abgezwickt werden. Dies ist eine sehr mühselige, zeit- und kostenaufwendige Arbeit.

Der vorliegenden Erfindung liegt die Aufgabe zugrunde, Schaltungselemente auf einfache Art und Weise von den Leiterplatten zu entfernen.

Zur Lösung dieser Aufgabe führt, daß eine bestückte Leiterplatte mit einem Mittel zur Lösung der Bestückungsverbindung, wie Wärme, eine Chemikalie od.dgl. beaufschlagt und die Bestückung sodann mechanisch entfernt wird.

Bekanntermaßen geschieht die Festlegung der Schaltungselemente auf Leiterplatten in der Regel durch Verlötung, d.h. die Schaltungselemente werden mit ihren Anschlußfahnen durch eine Leiterplatte hindurchgesteckt und an der entsprechenden Stelle ein Zinntropfen zur Verbindung mit der entsprechenden Leiterbahn angebracht. Gemäß der vorlieggenden Erfindung wird diese Verbindung einfach rückgängig gemacht, so daß die Anschlußfahnen der Schaltungselemente frei sind und diese dann auf einfachem Weg mechanisch von der Leiterplatte entfernt werden können.

In einzelnen Fällen genügt beispielsweise das Beaufschlagen der Leiterplatten mit Warmluft, Infrarot od.dgl, bis das Zinn geschmolzen ist. Denkbar sind auch entsprechende Chemikalien, welche die Anlötung auflösen. Sodann wird die Leiterplatte gegen einen Anschlag geschlagen, so daß die Schaltungselemente aus ihrer Halterung herausfliegen. Dieses Verfahren ist aber nur in seltenen Ausnahmefällen anwendbar, soll jedoch auch von der vorliegenden Erfindung mitumfaßt sein. Dies gilt vor allem sowohl für die Frage der Wärmequelle als auch für die Art der mechanischen Behandlung.

In einem bevorzugten Ausführungsbeispiel für eine automatisierte Entfernung wird jedoch die bestückte Leiterplatte in ein Zinn-Bad, insbesondere ein Blei-Zinn-Bad getaucht. Auf diese Weise kann die Anlötstelle am schnellsten aufgeschmolzen werden. Es genügt hier ein Tauchvorgang von ca. 10 Sekunden, bei dem sämtliche Anlötstellen einer Leiterplatte auf einmal aufgeschmolzen werden. Danach wird die bestückte Leiterplatte entweder gegen einen Anschlag gefahren, geschlagen oder dgl.,so daß die Schaltungselemente aus der Leiterplatte herausfallen. Bevorzugt wird jedoch für eine mechanische Behandlung der Leiterplatte ein Abbürsten, Abstreifen oder ein ähnliches mechanisches Verfahren.

Die Erfindung bezieht sich vor allem auch auf ein bevorzugtes Ausführungsbeispiel einer Vorrichtung zum automatischen Entfernen von Leiterplattenbestückungen. Hierbei ist ein Hebel zum Halten einer Leiterplatte über einem Zinn-Bad angeordnet, wobei der Hebel um eine Drehachse dreht.

Je nach Drehung des Hebels wird die Leiterplatte in das Zinn-Bad getaucht oder wieder angehoben. Zur Automatisierung des Verfahrens ist eine Kurvenscheibe vorgesehen, welche den Hebelfuß des Hebels gegenüber der Leiterplatte angreift. Diese Kurvenscheibe besteht aus einem Kurvenabschnitt, der einen Radius aufweist, so daß die Leiterplatte über das Zinn-Bad angehoben ist. Auf diesen Kurvenabschnitt folgt eine Steigfläche, welche bewirkt, daß der Hebelfuß angehoben und damit auf der anderen Seite die Leiterplatte abgesenkt wird. Danach gleitet der Hebelfuß über einen gewissen Zeitabschnitt auf einer Gleitfläche mit einem Radius, welcher größer ist als der Radius des Kurvenabschnittes. D.h., die Leiterplatte bleibt in das Zinn-Bad eingetaucht, so daß die Lötstellen aufgeschmolzen werden können.

An die Gleitfläche schließt dann ein Rücksprung wieder zum Kurvenabschnitt an. Da bevorzugt der Hebel unter dem Druck einer Schraubenfeder steht, geschieht die Rückführung der Leiterplatte aus dem Bad in die angehobene Stellung schlagartig, so daß hier bereits Schaltungselemente aus der Leiterplatte fallen.

Ferner ist daran gedacht, die Leiterplatte zwischen dem eben beschriebenen Hebel und einem Gegenhebel zu halten, wobei Hebel und Gegenhebel ein Drehgelenk bilden. Damit sind Hebel und Gegenhebel ähnlich einer Zange ausgebildet, wobei sie bevorzugt auch eine veränderbare Öffnungsweite ausbilden, welche je nach Breite der Leiterplatte eingestellt werden kann. Der Gegenhebel wird im übrigen über eine Schraubenfeder gegen einen ortsfesten Anschlag abgestützt. Ferner wird der Gegenhebel von einer Exzenterscheibe angegriffen, über welche wiederum das Öffnen des Gegenhebels bewirkt werden kann.

Bevorzugt soll der Gegenhebel aber nur der Grobeinstellung der Öffnungsweite dienen. Für die Feineinstellung ist an dem Gegenhebel noch ein Ausgleichsgestänge vorgesehen, welches dann einer vorgegebenen Breite der Leiterplatte genauestens Rechnung tragen kann. Das Ausgleichsgestänge besteht in einem Ausführungsbeispiel aus zwei Scherenhebel, welche einen gemeinsamen Drehpunkt am Gegenhebel besitzen. Auch dieser Drehpunkt ist veränderbar. Die einen Scherenhebelenden sind über ein Teleskopgesstänge miteinander verbunden, wodurch ein Öffnen und Schließen der Scherenhebel bewirkt werden kann. Die anderen Enden halten eine Klemmleiste, welche in Gebrauchslage an die Kante der Leiterplatte angelegt wird. Bevorzugt ist dabei ein Scherenhebel fest mit der Klemmleiste verbunden, während das andere Scherenhebelende in einem Langloch in der Klemmleiste gleitet.

Für die mechanische Bearbeitung der Leiterplatte ist an eine Bürste gedacht, welche über dem Zinn-Bad bzw. über der Leiterplatte angeordnet ist. Diese Bürste soll über die Leiterplatte führbar sein, wobei sie rotiert und beim Rotieren die Schaltungselemente aus der Leiterplatte herauszieht. Hierzu kann es sich beispielsweise anbieten, daß die Borsten der Bürste entsprechende Formen, beispielsweise Hakenformen besitzen. Ob dies notwendig ist, wird die Praxis zeigen.

Bevorzugt soll auch die mechanische Bearbeitung durch die Bürste automatisch erfolgen. Hierzu ist erfindungsgemäß die Bürste an einem Schlitten angeordnet, welcher über eine Schubstange od.dgl. Verbindungsmittel mit einer Scheibe exzentrisch verbunden ist. Beim Drehen der Scheibe um eine Achse wird der Schlitten hin- und her bewegt, wobei die Bürste über die Leiterplatte fährt.

Bevorzugt ist daran gedacht, die Scheiben für die Schlittenführung mit der Kurvenscheibe an einer Drehachse zu koppeln und mit einem Antrieb zu verbinden. Dementsprechend ist dann auch die Kurvenscheibe ausgestaltet. Damit jedoch keine Probleme auftauchen, falls die Bürste an der Leiterplatte hängen bleiben sollte, ist zwischen Scheibe und Kurvenscheibe eine Rutschkupplung vorgesehen.

Eine derartige Vorrichtung gewährleistet ein automatisches Entfernen von Leiterplattenbestückungen auf einfachem aber sicherem Wege.

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in
- Fig. 1: eine Seitenansicht einer erfindungsgemäßen Vorrichtung zum Entfernen von Leiterplattenbestückungen;
- Fig. 2: eine Draufsicht auf die Vorrichtung gem.Fig. 1;
- Fig. 3: eine Draufsicht - auf ein Element der Vorrichtung gem. Fig. 1.

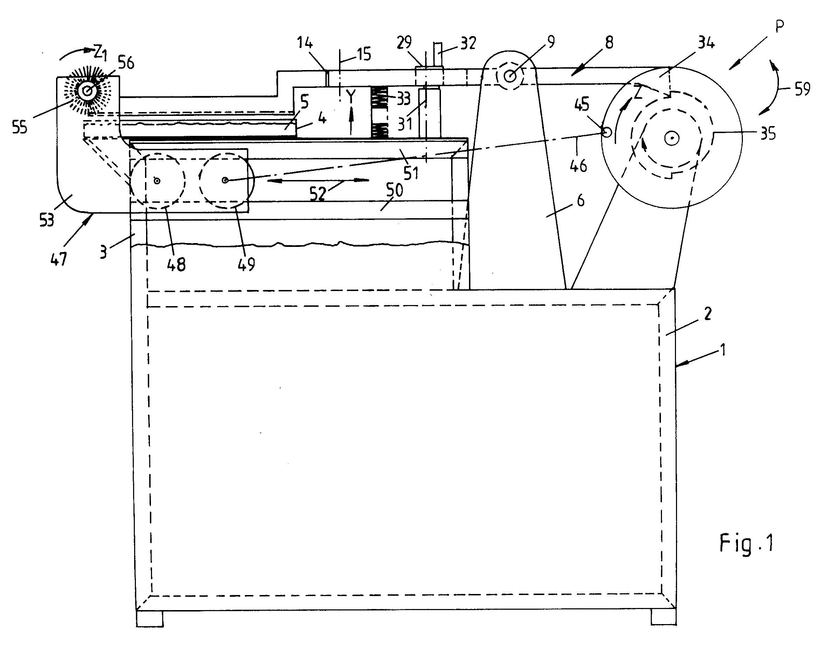

Eine erfindungsgemäße Vorrichtung P zum Entfernen von Leiterplattenbestückungen weist gem. Fig 1 ein Maschinengestell 1 mit einem Grundrahmen 2 auf. Auf diesem Grundrahmen 2 sitzt ein Tragrahmen 3, der auf seiner Oberseite einen Behälter 4 für ein Zinn-Bad 5, insbesondere ein Blei-Zinn-Bad trägt. Dieses Zinn-Bad 5 ist über nicht näher gezeigte Einrichtungen beheizbar, so daß es in flüssigem Zustand gehalten wird.

Neben dem Tragrahmen 3 sind mit dem Grundrahmen 2 zwei Lagerwangen 6 und 7 verbunden, welche zwischen sich einen Hebel 8 aufnehmen. Der Hebel 8 bildet zusammen mit den Lagerwangen 6 und 7 ein Drehgelenk 9, um welches der Hebel 8 in Richtung des Doppelpfeiles 59 schwenkbar ist.

Über dem Zinn-Bad 5 besitzt der Hebel 8 eine seitliche Nut 10, in welche eine nicht näher gezeigte Leiterplatte mit einer Seitenkante eingesetzt werden kann. Die gegenüberliegende Seitenkante der Leiterplatte wird von einem Ausgleichsgestänge 11 gehalten, welches einen Drehpunkt 12 mit einem Z-förmigen Gegenhebel 13 bildet. Dieser Gegenhebel 13 sitzt in einer Aussparung 14 in dem Hebel 8 und bildet dort mit dem Hebel 8 ein Drehgelenk 15.

Die grundsätzliche Öffungsweite a zwischen dem Hebel 8 und dem Gegenhebel 13 wird durch die Verbindung des Gegehebels 13 mit dem Hebel 8 im Drehgelenk 15 bestimmt. Zu dieser Bestimmung weist der Gegenhebel 13 zusätzlich Bohrungen 16 auf, welche jeweils als Teil des Drehgelenkes 15 dienen können.

Die Feineinstellung gegenüber einer Leiterplatte erfolgt mittels des Ausgleichsgestänges 11. Dieses Ausgleichsgestänge 11 besteht aus zwei Scherenhebeln 17 und 18, weiche entsprechende Durchgangsbohrungen 19 besitzen, die jeweils den Drehpunkt 12 bilden können. Einends sind die Scherenhebel 17 und 18 durch ein Teleskopgestänge 20 miteinander verbunden, welches der Einfachheit halber aus einer Gewindestange 21 und einer Hülsenmutter 22 besteht. Durch ein mehr oder minderes Einschrauben der Gewindestange 21 in die Hülsenmutter 22 wird der Abstand der beiden Scherenhebelenden bestimmt.

Die gegenüberliegenden Enden der Scherenhebel 17 und 18 sind über eine Klemmleiste 23 miteinander verbunden. In Gebrauchslage greift diese Klemmleiste 23 die andere Seitenkante der Leiterplatte an, wobei auch hier in der Klemmleiste 23 eine entsprechende Haltenut 24 vorgesehen ist. Der eine Scherenhebel 18 ist gelenkig aber ortsfest mit der Klemmleiste 23 verbunden, während der andere Scherenhebel 17 einen Gleitbolzen 25 besitzt, der in einem Langloch 26 in der Klemmleiste 23 gleitet. Über das oben beschriebene Teleskopgestänge 20 erfolgt eine Feineinstellung der Abstützung gegenüber einer Leiterplatte.

Um den Gegenhebel 13 in Schließlage zu halten, stützt sich an dem Gegenhebel 13 in der Nähe des Drehgelenks 15 eine Schraubenfeder 27 zwischen dem Gegenhebel 13 und einem ortfesten Anschlag 28 ab.

Eine Öffnungsbewegung des Gegenhebels 13 wird über eine Exzenterscheibe 29 bewirkt, welche in Richtung des Doppelpfeiles 30 um eine excentrische Drehachse 31 drehbar ist. Zur Drehung ist ein entsprechender Drehhebel 32 vorgesehen.

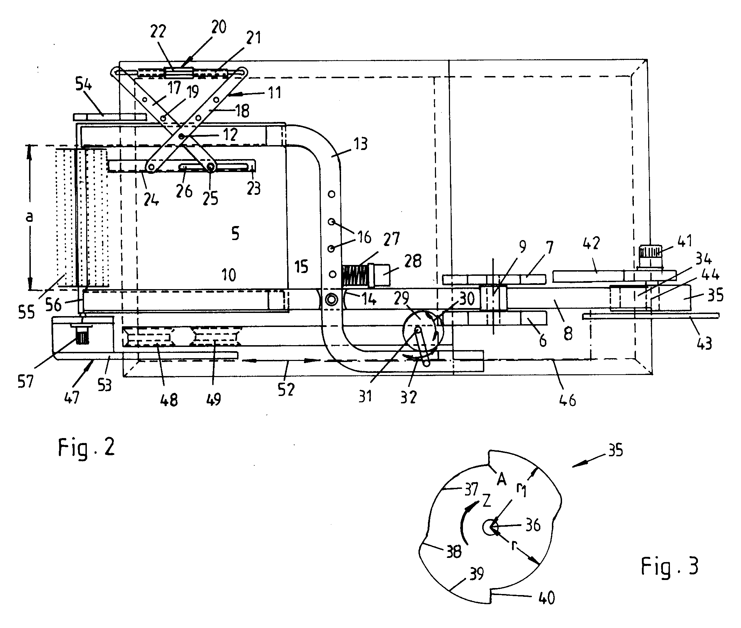

Auch der Hebel 8 steht unter dem Aufwärtsdruck einer Schraubenfeder 33, welche den Hebel in Richtung y drückt. Dabei wird ein Hebelfuß 34 in Anlage an einer Kurvenscheibe 35 gehalten. Diese Kurvenscheibe 35 ist in Fig.3 näher dargestellt. Sie dreht um eine Achse 36 in Richtung z und weist auf ihrem Umfang eine besondere Gestaltung auf, wobei dieser Umfang die Bewegung des Hebels 8 bestimmt. Beginnend bei Punkt A entgegen der Drehrichtung z folgt ein Kurvenabschnitt 37, der keine Bewegung des Hebels 8 bewirkt, da sein Radius r gleichbleibend ausgestaltet ist.

Auf den Kurvenabschnitt 37 folgt eine Steigfläche 38, auf der der Hebelfuß 34 aufgleitet. Das bedeutet, daß sich das gegenüberliegende Ende des Hebels 8 und der Gegenhebel 13 absenken, wobei eine gehaltene Leiterplatte in das Zinn-Bad 5 getaucht wird. Es folgt dann eine wieder kreisförmig um die Achse 36 verlaufende Gleitfläche 39 mit einem Radius r 1, der größer ist als der Radius r. Danach folgt ein plötzlicher Rücksprung 40 auf einen Kurvenabschnitt 37 mit dem Radius r, wobei die Leiterplatte über den Hebel 8 und den Gegenhebel 13 aus dem Zinn-Bad 5 gehoben wird.

Die Kurvenscheibe 35 befindet sich zusammen mit einem Antrieb 41 an einer Lagerlasche 42, welche dem Grundrahmen 2 aufsitzt.

Ferner ist die Kurvenscheibe 35 über eine nicht näher gezeigte Rutschkupplung mit einer Scheibe 43 verbunden, wobei Kurvenscheibe 35 und Scheibe 43 eine gemeinsame Drehachse 44 aufweisen und von dem Antrieb 41 angetrieben werden.

Die Scheibe 43 ist exzentrisch über einen Exzenter 45 und eine nur strichpunktiert angedeutete Schubstange 46 mit einem Schlitten 47 gekoppelt, welcher in dem Tragrahmen 3 bewegbar angeordnet ist. Hierzu sind am Schlitten 47 zwei Laufrollen 48 und 49 vorgesehen, welche sich zwischen Schienenstreifen 50 und 51 in Richtung des Doppelpfeiles 52 bewegen. Dabei befinden sich die Laufrollen 48 und 49 an einer Seitenwange 53 des Schlittens 47.

Es versteht sich von selbst, daß gegenüber der Seitenwange 53 eine weitere Seitenwange des Schlittens 47 vorgesehen ist, an der nicht näher gezeigte Laufrollen festliegen, Ein Teil dieser Seitenwange ist mit 54 gekennzeichnet.

Zwischen den beiden Seitenwangen 53 und 54 ist eine Bürste 55 angeordnet, welche um eine Achse 56 dreht. Die Drehrichtung ist mit z 1 gekennzeichnet. Ein entsprechender Antrieb 57 für die Bürste 55 dreht die Bürste 55 in Drehrichtung z 1.

Die Funktionsweise der vorliegenden Erfindung ist die folgende:
Eine mit Schaltungselementen bestückte Leiterplatte wird zwischen dem Hebel 8 und dem Gegehebel 13 bzw. die Klemmleiste 23 eingespannt, indem der Gegenhebel 13 mittels der Exzenterscheibe 29 um das Drehgelenk 15 gedreht wird. Sollte die Leiterplatte eine unterschiedliche Breite aufweisen, welche ein Klemmen zwischen Hebel 8 und Gegenhebel 13 nicht gestattet, so kann zum einen der Gegenhebel 13 relativ zum Hebel 8 lageverändert werden, indem eine der anderen Bohrungen 16 als Drehgelenkbohrung 15 benutzt wird. Eine Feineinstellung erfolgt mittels des Ausgleichsgestänges 11, wobei auch hier wiederum entsprechende unterschiedliche Durchgangsbohrungen 19 als Drehpunkt 12 Verwendung finden können. In jedem Fall befindet sich die Leiterplatte in Arbeitslage in der Nut 10 des Hebels 8 und in der Haltenut 24 der Klemmleiste 23.

Nunmehr wird der Antrieb 41 in Tätigkeit versetzt, wobei dieser Antrieb 41 sowohl die Kurvenscheibe 35 als auch die Scheibe 43 dreht. Die Rutschkupplung zwischen den beiden Scheiben hat dabei den Zweck, daß ein Hängenbleiben der Bürste 55 beispielsweise an einem Leiterplattenlelement nicht zu einer Störung der weiteren Drehung der Kurvenscheibe 35 führt.

Die Drehung der Scheibe 43 bewirkt, daß der Schlitten 47 über die Schubstange 46 nach rechts geführt wird, wobei die Laufrollen 48 und 49 in den Schienen 50 und 51 laufen. Auf diese Weise wird die Bürste 55 in eine Arbeitsposition nach rechts bewegt.

Nach etwa 90 Grad gleitet der Hebelfuß 34 die Steigfläche 38 der Kurvenscheibe 35 empor, wodurch der vordere Bereich des Hebels 8 und des Gegenhebels 13 abgesenkt und die Leiterplatte in das Zinn-Bad 5 getaucht wird. In diesem Bad 5 verbleibt die Leiterplatte bis zum Ende der Gleitfläche 39, was etwa eine Zeit von 10 Sekunden in Anspruch nimmt. Nach einer Drehung um 180 Grad befindet sich zum einen die Bürste 55 in ihrer am weitesten rechts orientierten Arbeitsposition, zum anderen überschreitet der Hebelfuß 34 die Kante des Rücksprunges 40 und fällt schlagartig untor dem Druck der Schraubenfeder 33 auf den Kurvenabschnitt 37 zurück. Hierdurch wird bewirkt, daß auch die Leiterplatte schlagartig angehoben wird und bereits dabei gelöste Bauelemente aus der Leiterplatte fallen.

Da gleichzeitig der Exzenter 45 seinen oberen Scheitelpunkt bei 180 Grad überschritten hat, wird der Schlitten 47 wieder nach links bewegt und die Bürste 55 über die Leiterplatte geführt. Da sie sich dabei in Drehung in Richtung z 1 befindet, bürstet sie die Bauelemente nach außen ab.

Bei dem eben beschriebenen Ausführungsbeispiel bietet es sich an, daß die Kurvenscheibe 35 nur einen Rücksprung 40 besitzt, da der Hebel 8 beim Rücklauf des Schlittens 47 in angehobener Position bleiben sollte. Im Rahmen der Erfindung ist aber auch daran gedacht, daß die Scheibe 43 doppelt so schnell läuft wie die Kurvenscheibe 35. In diesem Fall können, wie in Fig. 3 gezeigt, zwei Rücksprünge vorhanden sein. Hier soll der vorliegenden Erfindung keine Grenze gesetzt sein.

## Patentansprüche

1. Verfahren zum Entfernen von Leiterplattenbestückungen, welche mit der Leiterplatte über Anschlußfahnen od. dgl. verbunden sind,
dadurch gekennzeichnet,
daß eine bestückte Leiterplatte mit einem Mittel zur Lösung der Bestückungsverbindung, wie Wärme, eine Chemikalie od.dgl. beaufschlagt und die Bestückung sodann mechanisch entfernt wird.

2. Verfahren nach Anspruch 1, dadurch gekennzeichnet, daß die bestückte Leiterplatte in ein Zinn-Bad, insbesondere ein Blei-Zinn-Bad getaucht wird.

3. Verfahren nach Anspruch 2, dadurch gekennzeichnet, daß der Tauchvorgang ca 10 sec. durchgeführt wird.

4. Verfahren nach einem der Ansprüche 1 - 3, dadurch gekennzeichnet, daß die bestückte Leiterplatte nach der Wärmebehandlung gegen einen Anschlag gefahren, geschlagen od.dgl. wird.

5. Verfahren nach wenigstens einem der Anprüche 1 - 4, dadurch gekennzeichnet, daß die Leiterplatte bzw. die Bestückung von der Leiterplatte abgebürstet wird.

6. Vorrichtung zum Entfernen von Leiterplattenbestückungen, dadurch gekennzeichnet, daß die Leiterplatte von einem Hebel (8) über einem Zinn-Bad (5) gehalten ist, wobei der Hebel (8) um eine Drehachse (9) dreht und die Leiterplatte in das Zinn-Bad (5) taucht.

7. Vorrichtung nach Anspruch (6), dadurch gekennzeichnet, daß ein Hebelfuß (34) des Hebels (8) gegenüber der Leiterplatte eine Kurvenscheibe (35) abläuft, welche den Tauchvorgang bewirkt.

8. Vorrichtung nach Anspruch 7, dadurch gekennzeichnet, daß die Kurvenscheibe (35) aus einem Kurvenabschnitt (37) besteht, der einen Radius (r) aufweist, und daß sich daran eine Steigfläche (38) und nachfolgend eine Gleitfläche (39) mit einem Radius (r 1) anschließt, der größer ist als der Radius (r).

9. Vorrichtung nach Anspruch 8, dadurch gekennzeichnet, daß nach der Gleitfläche (39) ein Rücksprung (40) zum Kurvenabschnitt (37) erfolgt.

10. Vorrichtung nach wenigstens einem der Ansprüche 6 - 9, dadurch gekennzeichnet, daß zwischen Drehachse (9) und Leiterplatte eine Schraubenfeder (33) den Hebel (8) in Druckrichtung (y) abstützt.

11. Vorrichtung nach wenigstens einem der Ansprüche 6 - 10, dadurch gekennzeichnet, daß die Leiterplatte zwischen dem Hebel (8) und einem Gegenhebel (13) gehalten ist, wobei Hebel (8) und Gegenhebel (13) ein Drehgelenk (15) bilden.

12. Vorrichtung nach Anspruch 11, dadurch gekennzeichnet, daß Hebel (8) und Gegenhebel (13) eine veränderbare Öffnungsweite (a) ausbilden.

13. Vorrichtung nach Anspruch 11 oder 12, dadurch gekennzeichnet, daß sich der Gegenhebel (13) über eine Schraubenfeder (27) gegen einen ortsfesten Anschlag abstützt.

14. Vorrichtung nach einem der Ansprüche 11 - 13, dadurch gekennzeichnet, daß der Gegenhebel (13) von einer Exzenterscheibe (29) angegriffen ist, welche ein Öffnen des Gegenhebels (13) bewirkt.

15. Vorrichtung nach wenigstens einem der Ansprüche 11 - 14, dadurch gekennzeichnet, daß am Gegenhebel (13) ein Ausgleichsgestänge (11) vorgesehen ist.

16. Vorrichtung nach Anspruch 15, dadurch gekennzeichnet, daß das Ausgleichsgestänge (11) aus zwei Scherenhebeln (17, 18) besteht, welche einen gemeinsamen Drehpunkt (12) am Gegenhebel (13) besitzen.

17. Vorrichtung nach Anspruch 16, dadurch gekennzeichnet, daß die einen Scherenhebelenden über ein Teleskopgestänge (20) miteinander verbunden sind.

18. Vorrichtung nach Anspruch 17, dadurch gekennzeichnet, daß die anderen Scherenhebelenden über eine Klemmleiste (23) miteinander verbunden sind, wobei ein Ende in einem Langloch (26) gleitet.

19. Vorrichtung nach wenigstens einem der Ansprüche 6 - 18, dadurch gekennzeichnet, daß dem Zinn-Bad (5) eine Bürste (55) zugeordnet ist.

20. Vorrichtung nach Anspruch 19, dadurch gekennzeichnet, daß die Bürste (55) über die Leiterplatte führbar ist.

21. Vorrichtung nach Anspruch 10, dadurch gekennzeichnet, daß die Bürste (55) an einem Schlitten ((47) angeordnet ist, welcher über eine Schubstange (46) od.dgl. Verbindungsmittel mit einer Scheibe (43) exzentrisch verbunden ist.

22. Vorrichtung nach Anspruch 21, dadurch gekennzeichnet, daß die Scheibe (43) zusammen mit der Kurvenscheibe (35) an einer Drehachse (44) angeordnet und mit einem Antrieb (41) verbunden ist.

23. Vorrichtung nach Anspruch 22, dadurch gekennzeichnet, daß sich zwischen Scheibe (43) und Kurvenscheibe (35) eine Rutschkupplung befindet.
